# FASCICULE DE BREVET EUROPEEN

(11) **EP 1 094 471 B1**
(45) Date de publication et mention de la délivrance du brevet: **02.01.2003**
(21) Numéro de dépôt: 00402906.2
(22) Date de dépôt: 19.10.2000
(51) Int. Cl.: G11C 29/00

(54) **Procédé de test de composants électroniques**
Verfahren zur Prüfung von elektronischen Bauteilen
Method for electronic component testing

(30) Priorité: 21.10.1999 FR 9913396
(43) Date de publication de la demande: 25.04.2001
(73) Titulaire: Softlink, 91410 Dourdan (FR)
(72) Inventeur: Lejeune, Philippe, 28630 Sours (FR)
(74) Mandataire: Schmit, Christian Norbert Marie

(56) Documents cités:
- EP-A- 0 867 887
- WO-A-99/44752
- US-A- 5 506 849
- US-A- 5 841 789
- K. JACKSON AND B.E. SEAR: "Measurement techniques for testing high speed memories" COMPUTER DESIGN, vol. 14, no. 5, mai 1975 (1975-05), pages 127-132, XP002142818

## Description

La présente invention a pour objet un procédé de test de composants électroniques. Elle trouve plus particulièrement son utilisation dans le domaine des tests réalisés sur des lots de composants électroniques, en sortie de lignes de fabrication, notamment pour des tests réalisés sur des composants électroniques de type mémoire, et en particulier de type mémoire flash. Dans l'état de la technique, on connaît des procédés de tests qui sont répétés à l'identique sur des composants d'un même type, ces composants étant issus d'un même lot de fabrication, ou issus d'une ou plusieurs lignes de fabrication. L'intérêt de l'invention est de proposer un procédé de tests permettant de diminuer progressivement une durée de réalisation d'un même test à effectuer sur un même type de composants.

Dans l'état de la technique, on connaît une machine pour tester des composants électroniques, tels que des composants mémoire d'un circuit intégré. Généralement, à une sortie d'une ligne de production, des composants mémoires sont disposés sur des plaquettes, appelées « wafer ». Un wafer peut comporter jusqu'à une centaine de composants mémoire à tester. Chacun des composants mémoires d'un wafer est testé intégralement, et ce de manière individuelle et indépendamment des autres tests à réaliser sur d'autres composants du wafer.

Un composant électronique comporte principalement des cellules et des entrées et des sorties, ces entrées et sorties permettant de communiquer avec des entrées et sorties des cellules. Par exemple, un composant mémoire peut être constitué de 256 K cellules mémoires, tel que chacune des cellules mémoires comporte une entrée et une sortie. D'autre part, ce composant mémoire peut comporter dans un exemple 32 entrées et 32 sorties. Généralement, une cellule mémoire d'un tel composant électronique est un transistor. Dans un exemple, ce transistor peut présenter 8 états de sortie différents. Dans cet exemple, pour des composants mémoires à tester, une cellule mémoire peut alors être placée à 8 niveaux distincts de tension, ces niveaux étant compris entre 1,5 et 2,5 volts, étant donné la taille des composants mémoires. Un niveau de tension de la cellule mémoire est alors codé en 3 bits.

Dans l'état de la technique, on connaît donc des machines de test capables d'effectuer, successivement sur chacune des cellules mémoires d'un composant mémoire, des tests pour déterminer si le composant mémoire est valable. La nature et les modalités de réalisation des tests sont généralement précédemment définies de manière théorique. Notamment, on prévoit de manière théorique un motif historique de signaux de tests à envoyer dans chacune des cellules à tester, et on définit de manière théorique, en fonction de ces signaux de tests, des motifs d'états par lesquels la cellule mémoire doit théoriquement passer étant donné la nature et le motif historique du signal initial envoyé.

Etant donné que les motifs historiques des tests théoriques sont établis au démarrage, lors de la conception d'un composant, les temps de tests déterminés pour tester ce composant prennent en compte des marges de sécurité considérables vis-à-vis de la réussite des tests. Par ailleurs les motifs historiques de test et leur durée de mise en oeuvre ne tiennent pas compte des améliorations de la production réalisées. En effet, une modification d'un des motifs historiques de test ou sa durée peut avoir des conséquences difficiles à évaluer de manière théorique. Donc les motifs historiques des test théoriques initiaux ne sont pas modifiés, ou s'ils le sont, c'est très rarement. Les durées des tests sont donc très nettement surévaluées par rapport à ce qu'elles pourraient être. Donc dans l'état de la technique, la réalisation de tels tests sur des composants électroniques est très longue.

Dans l'état de la technique, on connaît pour diminuer légèrement la durée de test globale d'un composant électronique un procédé de test dans lequel on teste plusieurs cellules du composant simultanément. En effet étant donné qu'un composant peut comporter jusqu'à 32 entrées, on peut donc tester, dans ce cas, jusqu'à 32 cellules de ce composant simultanément. Chaque test consistant à l'envoi d'un signal électrique non monotone pendant une certaine durée, des problèmes de couplage de signaux peuvent apparaître. En effet de manière théorique on définit des tests tels que ces tests peuvent être envoyés simultanément. Par contre, si l'on cherche à modifier certains de ces tests, on risque de voir surgir ces phénomènes de couplage. En effet, les combinaisons des différents signaux envoyés sur les 32 entrées du composant vers 32 cellules à tester de ce composant étant excessivement complexes, elles ne peuvent pas faire l'objet d'une optimisation facile. Donc dans l'état de la technique, les procédés de test établis sont maintenus en l'état, et aucune optimisation continue n'est mise en place.

L'invention a pour objet de remédier aux problèmes cités en proposant un procédé de test permettant d'optimiser progressivement la durée d'un test réalisé sur un composant électronique. La solution apportée par l'invention consiste en un procédé pour tester un composant électronique tel que dans un premier temps, on envoie un signal à une cellule à tester du composant. Ce premier signal envoyé est non monotone. Généralement, il a une forme complexe, et il est défini par un motif historique qui est un enchaînement de variations de valeurs pendant une certaine durée.

Le signal peut par exemple être émis à partir d'un convertisseur analogique numérique traduisant une table de valeurs correspondant aux valeurs du motif historique à effectuer. Le convertisseur analogique numérique est alors commandé par une horloge qui permet de définir une vitesse d'émission du signal électrique et donc la durée de ce signal. Ce signal est envoyé à une cellule en particulier du composant à tester.

La cellule réceptrice émet après un certain temps une réponse. On mesure cette réponse, qui est généralement du type d'un signal électrique comportant un motif d'états électrique par lequel la cellule passe sous l'effet du signal reçu. Etant donné que la cellule peut, dans l'exemple particulier évoqué, être placée dans 8 états différents, un motif d'états de la cellule peut par exemple être représenté par une courbe en escaliers à huit paliers. Ensuite, on juge si ce motif d'états obtenu est conforme vis-à-vis d'un motif d'états attendus. C'est à dire que l'on compare le motif des états obtenus à des critères d'acceptation soit inférieurs soit supérieurs pour des étapes élémentaires du motif d'états.

Le procédé selon l'invention propose de réaliser le test à nouveau en comprimant la durée du motif historique du signal initial. Ainsi on envoie le même signal ayant globalement les mêmes caractéristiques que le premier signal envoyé, sauf qu'il se réalise sur une durée réduite. Il s'ensuit que le motif d'états par lequel passe la cellule est plus vite réalisé, et que ce motif d'états lui-même a une durée plus courte. Ensuite, si le motif d'états comprimé obtenu est conforme ou non à un motif d'états également comprimé attendu, on accepte ou on rejette le composant.

Le motif d'états comprimé attendu peut être obtenu en comprimant le motif d'états attendu initial de la même manière que le signal d'envoi initial a été comprimé pour donner le signal ayant le motif historique comprimé. Pour diminuer la durée des tests de manière progressive au fur et à mesure des tests de composants, on peut prévoir par exemple de prendre en compte ce nouveau motif historique de signal d'envoi comme étant le signal à envoyer à un nouveau composant à tester. Dans ce cas, on teste un nouveau composant immédiatement avec un temps de test comprimé.

L'invention concerne donc un procédé de test d'un composant électronique dans lequel
- on envoie un premier signal, d'une première durée, avec un premier motif historique non monotone à une première cellule du composant,
- on mesure un résultat représenté par un premier motif d'états électriques de la première cellule,
- on accepte le composant si le premier motif d'états est conforme à un motif attendu,
caractérisé en ce que
- on comprime la durée du motif historique du premier signal,
- on mesure un motif comprimé d'états correspondants, et
- on accepte le composant si le motif comprimé d'états est conforme à un motif comprimé attendu.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1 : Une vue d'un composant électronique à tester selon le procédé de l'invention ;
- Figure 2a : Un ensemble de motifs historiques de signaux du procédé de test selon l'invention ;
- Figure 2b : un ensemble de motifs d'états pouvant être obtenus avec un procédé de test selon l'invention ;
- Figure 3 : Un tableau de réduction progressive des durées de réalisation de tests selon le procédé de l'invention.

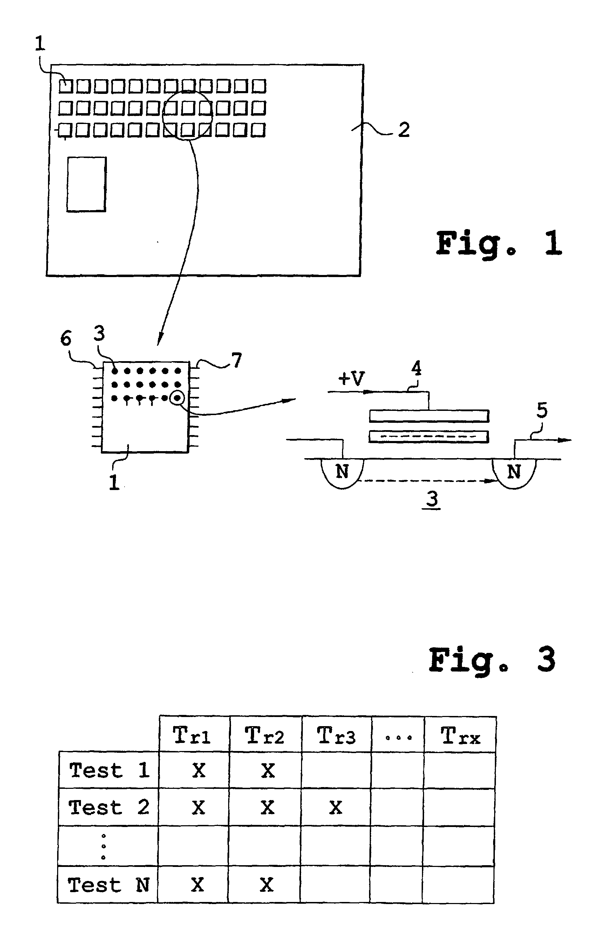

Un procédé de test selon l'invention a pour objet de tester un composant électronique 1, par exemple disposé sur une plaquette 2, comme représenté figure 1. La plaquette 2 peut comporter jusqu'à quelques milliers de composants électroniques tels que 1 à tester. La plaquette 2 est généralement appelée « wafer ». Dans un exemple préféré de l'invention, la plaquette 2 comporte des circuits intégrés électroniques comportant chacun au moins un composant mémoire 1. Le composant mémoire 1 peut par exemple être une mémoire de type flash-eprom. Chaque composant mémoire 1 disposé sur la plaquette 2 doit être testé selon un procédé de test de l'invention.

Plus particulièrement, un composant mémoire 1 comporte des cellules mémoire 3 telles que chacune des cellules mémoires 3 doit être testée. Plus généralement, toutes les cellules mémoires 3 de la plaquette 2 doivent être testées.

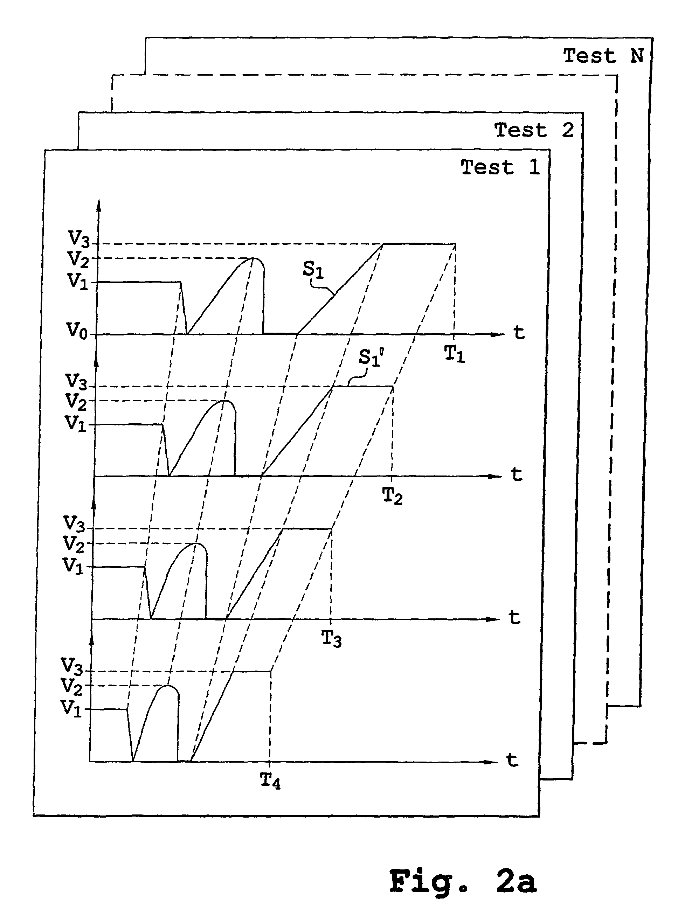

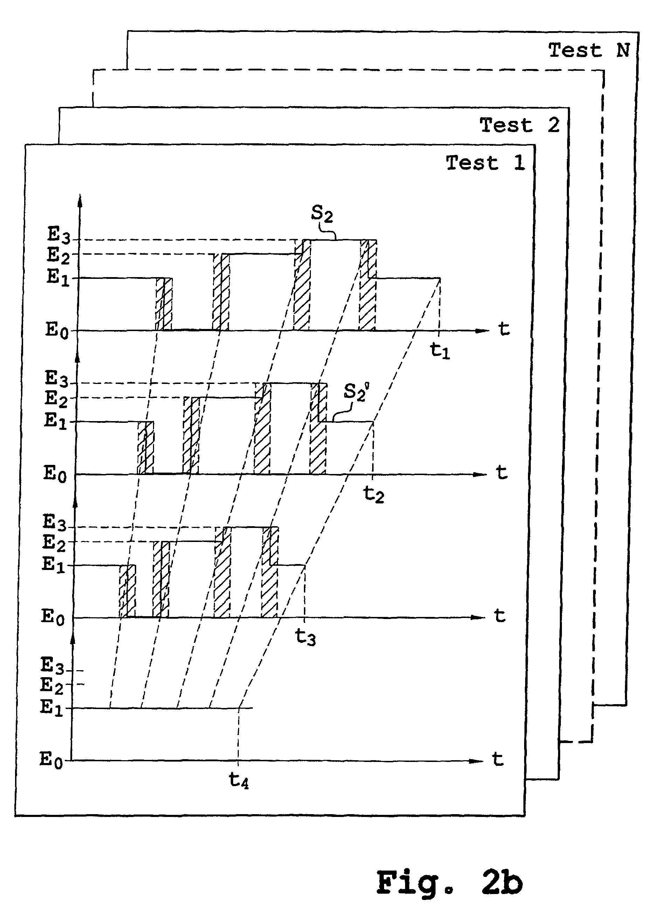

Une cellule mémoire 3 est par exemple un transistor. Par exemple, un transistor peut être un transistor simple. Dans l'exemple présenté figure 2, le transistor de la cellule mémoire 3 est un transistor muni d'une double grille tel qu'il comporte une voie d'entrée 4, pouvant recevoir des tensions variables, et tel qu'il comporte une voie de sortie 5 pour émettre un signal de sortie, en correspondance du signal d'entrée reçu et de l'état de mémorisation de la cellule mémoire. Le signal de sortie présente également des tensions variables. Dans l'exemple présenté figure 2, étant donné que le transistor comporte une double grille, un signal de sortie à la sortie 5 peut présenter jusqu'à 8 états différents.

Etant donné que les composants électroniques concernés sont très petits, il est nécessaire d'envoyer des signaux à basse tension. Donc, un signal d'entrée au niveau de la voie d'entrée 4 est généralement compris entre 1,5 et 2,5 volts. Un tel signal peut être émis dans la voie 4 par l'intermédiaire d'une des broches d'entrée 6 du composant mémoire 1. En effet la mémoire 1 peut par exemple comporter 16 ou 32 broches d'entrée et respectivement 16 ou 32 broches de sorties. Or généralement un composant 1 comporte plus de 32 cellules, donc un signal émis sur des broches d'entrée comporte également un signal d'adressage pour désigner une des cellules mémoires, parmi celles de la mémoire 1, à tester. Le signal émis sur la voie sortie 5 d'une cellule mémoire 3 est reçu au niveau d'une broche de sortie 7 du composant mémoire 1. Selon le nombre de broches d'entrée telles que 6 du composant mémoire 1, on peut communiquer avec un même nombre de cellules mémoires simultanément.

Le procédé de test selon l'invention du composant électronique 1 comporte notamment l'envoi d'un signal S1, présenté figure 2a. Le signal S1 est fourni pendant une durée de temps T1. Le signal S1 a une forme complexe, il est non monotone. En effet, pour un test Test1, le signal S1 présenté figure 2a, commence par une première phase stationnaire à une valeur V1, puis une brusque descente à une valeur V0, une remontée lente jusqu'à une valeur V2 puis une brusque redescente à la valeur V0 à nouveau, puis une remontée progressive linéaire jusqu'à une valeur V3 et enfin un palier à cette valeur V3. Cette forme est ici arbitraire. Elle montre le caractère non monotone, et complexe des premiers signaux. Le signal S1 est caractérisé par un motif historique. En effet les différentes évolutions entre les valeurs V0 V1 V2 et V3, et les durées relatives à chacune de ces valeurs forment le motif historique. Ce signal S1 est donc émis à une cellule 3 par l'intermédiaire de la voie d'entrée 4 de la cellule 3 et d'une borne d'entrée 6 du composant 1.

On récupère à la sortie 5 de la cellule 3 et finalement au niveau d'une broche de sortie 7 du composant 1, un résultat en conséquence du signal S1 envoyé. Ce résultat est constitué par une série d'états successifs par lesquels est passé la cellule 3 suite à la réception du signal S1. Par exemple un résultat peut être un signal S2 du type de celui présenté figure 2b. Dans cet exemple, le signal S2 est une succession, ici arbitraire, de plateaux à des valeurs distinctes : E1, puis E0, puis E2, puis E3, puis E1 à nouveau.

On compare ce signal S2 à un motif attendu d'états électriques, ou de résultats. Un motif attendu de résultats présente des critères d'acceptation inférieurs et/ou supérieurs. En effet, des critères d'acceptation du motif attendu peuvent être une tolérance vis-à-vis d'une durée exacte de chaque plateau, ou encore être une tolérance vis-à-vis du niveau du plateau lui-même à atteindre. Chaque plateau a une durée relative par rapport aux autres plateaux.

Si la cellule 3 est jugée acceptable vis-à-vis du test réalisé, on réalise à nouveau le test selon le procédé de l'invention sur cette cellule. Pour cela, on utilise un signal S1' tel que la durée du motif historique de S1' est proportionnelle à celle du motif historique du signal S1. Ce signal à envoyer S1' a une durée égale à T2, telle que T2 est inférieure à T1. En conséquence, on étudie un signal S2' en sortie de la cellule 3. Le signal S2' est constitué d'un motif comprimé d'états électriques de la cellule 3. On juge le composant acceptable si le motif comprimé d'états obtenu est conforme à un motif comprimé d'états attendu pour cette cellule. Généralement on s'attend à ce que le signal S2' soit temporellement proportionnel au signal S2 et tel que la différence entre le signal S2 et le signal S2' réside principalement dans une réduction proportionnelle des durées respectives des états traversés par la cellule. Des critères d'acceptation vis-à-vis de ce motif comprimé d'états sont donc respectivement réduits.

Dans une variante, on peut prévoir de comprimer seulement une portion temporelle du signal S1. On obtient donc une réponse du type de S2 qui est, si le test est validé, réduite également sur une même portion en correspondance.

Dans ces conditions, si la cellule 3 est jugée à nouveau conforme lorsqu'elle est testée avec le signal comprimé S1', alors on peut décider de tester d'autres cellules du composant électronique 1, ou d'autres composants électroniques tels que 1, en utilisant le signal d'entrée S1' pour la réalisation du test Test1. Ainsi pour chaque nouveau test réalisé, on gagne la différence de temps entre T1 et T2. Par ailleurs, on peut réitérer ce procédé de manière à diminuer progressivement la durée du test Test1, dans la limite où un signal de sortie obtenu reste conforme.

Dans une première variante, on peut décider de ne réaliser qu'une seule itération selon le procédé de l'invention par cellule du composant. On effectue ainsi une diminution progressive cellule par cellule du temps de test. Dans une deuxième variante, on peut décider de n'utiliser un temps de test comprimé qu'après avoir validé ce nouveau type de test sur plusieurs cellules successives.

Dans un exemple préféré de l'invention, pour comprimer la durée T1 du motif historique S1, on utilise une horloge. En effet, dans cet exemple les caractéristiques du signal S1 sont renseignées dans une table. La table est progressivement lue au rythme de l'horloge de telle façon qu'un convertisseur analogique numérique convertisse les données fournies par cette table en un signal électrique correspondant. L'horloge permet alors de définir un pas de transformation des valeurs inscrites dans la table par le convertisseur analogique numérique. Selon la taille du pas choisie, on obtient alors un signal ayant les mêmes caractéristiques de valeurs, mais pouvant être exécuté plus ou moins rapidement. Dans ce cas, quelle que soit la durée d'émission du signal correspondant, le signal S1 comporte un nombre identique d'échantillons prélevés dans la table.

Dans une variante, on dispose d'une horloge réglée avec un pas de transformation donné. Dans ce cas, pour faire varier la durée d'émission d'un signal donné, on peut procéder à la réalisation d'une table réduite. Cette table réduite est obtenue en réalisant un échantillonnage parmi les valeurs de la première table. Ainsi on obtient une deuxième table qui comporte globalement les mêmes caractéristiques que la première table, mais qui aboutira à un signal de durée inférieure à celle du signal obtenu avec la première table, car il correspondra à la lecture de moins d'échantillons. Cette variante est toutefois plus difficile à mettre en oeuvre car elle nécessite la création de tables multiples pour obtenir de multiples durées comprimées ou motifs historiques de signal envoyé désirés.

Une cellule d'un composant peut comporter plusieurs tests à réaliser. Par exemple on peut désirer réaliser des tests Test1, Test2, jusqu'à un TestN sur ce composant. Pour chacun de ces tests, on peut appliquer le procédé selon l'invention. Donc on peut comprimer pour chacun de ces tests, la durée d'envoi des signaux respectifs de type S1 ayant un motif historique non monotone. L'avantage de l'invention réside dans le fait que l'on peut comprimer de manière indépendante chacune de ces durées respectives à chacun des tests test 1, test 2, ... test N. Ainsi chaque test est optimisé de manière indépendante.

Par ailleurs un composant selon l'invention, notamment une mémoire 1, comporte plusieurs broches d'entrée telles que 6 et plusieurs broches de sortie telles que 7. On peut donc tester simultanément plusieurs cellules telles que 3 situées à l'intérieur de ce composant 1. En effet par l'intermédiaire de chacune des broches d'entrée 6, on peut respectivement atteindre autant de cellules 3 à l'intérieur du composant 1. On envoie donc sur chacune des cellules un signal de type S1 correspondant à un test donné. Les signaux envoyés, relatifs aux tests en cours de réalisation, peuvent même être différents d'une cellule à une autre. De même, on peut réduire selon le procédé de l'invention respectivement les durées des signaux d'envoi pour chacun de ces tests, les tests étant effectués chacun sur une cellule de manière indépendante.

Etant donné que dans ce cas des signaux sont émis simultanément sur des broches d'un même composant et donc situées à grande proximité, il y a des risques de rayonnement liés aux fréquences d'émission des signaux qui peuvent apparaître. En effet, on peut observer des phénomènes de couplage entre les signaux émis ou reçus par les différentes broches. Dans ce cas, le procédé selon l'invention propose de réaliser l'optimisation d'une durée de réalisation d'un test en réalisant toujours simultanément les tests qui doivent être envoyés simultanément sur l'ensemble des cellules à tester, de manière à tenir compte aussi de ces phénomènes de couplage lors de la compression de la durée d'un test selon le procédé de l'invention. En effet, si l'on modifie un des motifs de signal envoyés, cela peut interférer dans les autres signaux envoyés, ou dans les états électriques en résultant en sortie. Ainsi, comme il est présenté figure 3, on peut avoir effectué, successivement ou simultanément, tous les tests, Test1, Test2, TestN, avec un taux de compression Tr1. On peut ensuite effectuer ces tests avec un taux de compression plus fort Tr2 (durée plus courte). Le succès à ces tests du composant testé est considéré par une croix dans le tableau. Pour un taux Tr3, il est possible que seul le test Test2 rende un verdict bon, pour un composant dont on sait qu'il est bon puisqu'il a déjà satisfait à tous les tests avec le taux Tr2. Dans ce cas on aura déterminer que le taux Tr3, lors d'une campagne de test sur toutes les autres cellules ou circuits du composant 1 (ou sur d'autres composants) ne sera applicable qu'au test Test2, le taux Tr2 devant être appliqué aux autres tests. De ce fait on réalise simultanément les tests Test1 jusqu'à TestN avec des temps minima.

Dans le procédé de l'invention on peut établir un rapport entre le temps comprimé minimum obtenu suite à la réalisation d'un test, par exemple le test Test1, sur une cellule, 3, et le temps T1 initialement prévu. On peut ainsi définir des taux de compression. On peut définir un taux de compression réalisé pour une cellule donnée et pour un test donné. La connaissance de ces taux de compression peut permettre de juger la cellule, et plus globalement le composant électronique comprenant cette cellule, selon une grille d'évaluation qui peut être plus précise qu'un classement entre bon ou mauvais. En effet, on peut établir une grille de valeurs pour ces composants. On peut par exemple noter les composants conformes, et les classer selon leurs taux de compression obtenus aux différents tests. On peut ainsi classer les composants testés selon une gamme de valeurs permettant d'identifier parmi les bons ceux qui sont encore plus performants que ce qui était attendu. De même, on peut établir un classement parmi les composants mauvais.

Le procédé de test selon l'invention est également utilisé pour pouvoir vérifier les capacités de lecture et écriture d'un composant électronique, par exemple de type mémoire, au bout d'un certain temps. On procède donc à un vieillissement entre une opération de lecture qui correspond à un envoi d'un signal de type S1 et une opération de lecture qui correspond à une mesure d'un résultat de type S2. Ce vieillissement consiste notamment à faire subir des variations successives de température au composant. En effet en quelques heures, généralement 2 heures, on procède à cette opération de vieillissement qui correspond à un vieillissement théorique de 6 mois. On utilise ensuite le procédé de test selon l'invention sur des composants vieillis selon cette méthode

Lorsque l'on teste des cellules mémoire, généralement à la fin de chaque test on procède à un effacement total de la mémoire, de manière à rendre une mémoire complètement vierge à l'issue du test.

## Revendications

1. Procédé de test d'un composant électronique (1) dans lequel
- on envoie un premier signal (S1), d'une première durée (T1), avec un premier motif historique non monotone à une première cellule du composant,
- on mesure un résultat (S2) représenté par un premier motif d'états électriques de la première cellule,
- on accepte le composant si le premier motif d'états est conforme à un motif attendu,
**caractérisé en ce que**
- on comprime (T2) la durée du motif historique du premier signal,
- on mesure un motif comprimé d'états correspondants, et
- on accepte le composant si le motif comprimé d'états est conforme à un motif comprimé attendu.

2. Procédé selon la revendication 1 **caractérisé en ce que**
- on utilise une horloge pour déterminer un pas d'enchaînement d'éléments du premier motif historique, telle que le pas de cette horloge peut être diminué.

3. Procédé selon l'une des revendications 1 à 2 **caractérisé en ce que**
- on constitue une table à partir d'un échantillonnage du premier motif historique,
- une durée d'envoi d'un signal ayant pour motif historique une suite d'échantillons de cette table correspond à une durée comprimée du motif historique.

4. Procédé selon l'une des revendications 1 à 3 **caractérisé en ce que**
- on constitue une famille de tables à partir d'échantillonnages du premier motif historique,
- cette famille de tables représentant des motifs historiques possibles pour obtenir des motifs historiques comprimés avec des taux de compression différents.

5. Procédé selon l'une des revendications 1 à 4 **caractérisé en ce que**
- un test comporte plusieurs motifs historiques à tester sur la cellule du composant,
- on comprime différemment des durées respectives de différents motifs historiques de premiers signaux.

6. Procédé selon l'une des revendications 1 à 5 **caractérisé en ce que**
- on teste simultanément plusieurs circuits d'un même composant électronique.

7. Procédé selon la revendication 6 **caractérisé en ce que**
- on définit des taux de compression différents pour comprimer des motifs historiques de premiers signaux envoyés simultanément chacun vers un des circuits à tester.

8. Procédé selon l'une des revendications 1 à 7 **caractérisé en ce que**
- on qualifie le composant électronique en fonction d'un taux de compression mis en oeuvre pour comprimer la durée du motif historique du premier signal.

9. Procédé selon l'une des revendications 1 à 8 **caractérisé en ce que**
- on envoie à un circuit suivant d'un composant ou à un composant suivant, un premier signal ayant pour motif historique le motif historique comprimé défini pour un circuit ou un composant précédemment testé.

10. Procédé selon l'une des revendications 1 à 9 **caractérisé en ce que**
- on vieillit le composant en lui faisant subir des variations répétées de températures, puis
- on envoie un premier signal, d'une première durée, avec un premier motif historique non monotone à une première cellule du composant, et
- on mesure un résultat représenté par un premier motif d'états électriques de la première cellule.

11. Procédé selon l'une des revendications 1 à 10 **caractérisé en ce que**
- comme premier signal, on envoie un signal de programmation à une cellule mémoire d'une mémoire en circuit intégré du composant électronique, notamment une mémoire de type flash-eprom,
- on efface la cellule mémoire à la fin du test.

## Patentansprüche

1. Verfahren zur Prüfung eines elektronischen Bauteils (1), bei dem
ein erstes Signal (S1) einer ersten Dauer (T1) mit einem ersten, nicht monotonen Verlaufsmuster an eine erste Zelle des Bauteils geschickt wird,
das Ergebnis (S2), das durch ein erstes Muster von elektrischen Zuständen der ersten Zelle dargestellt wird, gemessen wird,
das Bauteil akzeptiert wird, wenn das erste Zustandsmuster mit einem erwarteten Muster übereinstimmt,
**dadurch gekennzeichnet, dass**
die Dauer (T2) des Verlaufsmusters des ersten Signals komprimiert wird,
ein komprimiertes Muster von entsprechenden Zuständen gemessen wird, und
das Bauteil akzeptiert wird, wenn das komprimierte Muster von Zuständen mit einem erwarteten komprimierten Muster übereinstimmt.

2. Verfahren nach Anspruch 1,
**dadurch gekennzeichnet, dass**
ein Takt verwendet wird, um einen Abfolgeschritt von Elementen des ersten Verlaufsmusters zu bestimmen, so dass der Schritt dieses Taktes verringert werden kann.

3. Verfahren nach Anspruch 1 oder 2,
**dadurch gekennzeichnet, dass**
aufgrund einer Abtastung des ersten Verlaufsmusters eine Tabelle aufgestellt wird,
eine Sendedauer eines Signals mit einer Abtastfolge dieser Tabelle als Verlaufsmuster einer komprimierten Dauer des Verlaufsmusters entspricht.

4. Verfahren nach einem der Ansprüche 1 bis 3,
**dadurch gekennzeichnet, dass**
aufgrund von Abtastungen des ersten Verlaufsmusters eine Familie von Tabelle aufgestellt wird,
wobei diese Familie von Tabellen mögliche Verlaufsmuster darstellt, um komprimierte Verlaufsmuster, die mit unterschiedlichen Kompressionsgraden komprimiert sind, zu erhalten.

5. Verfahren nach einem der Ansprüche 1 bis 4,
**dadurch gekennzeichnet, dass**
eine Prüfung mehrere Verlaufsmuster für das Prüfen der Zelle des Bauteils umfasst,
die jeweiligen Dauern der unterschiedlichen Verlaufsmuster der ersten Signale unterschiedlich komprimiert werden.

6. Verfahren nach einem der Ansprüche 1 bis 5,
**dadurch gekennzeichnet, dass**
gleichzeitig mehrere Schaltkreise eines gleichen elektronischen Bauteils geprüft werden.

7. Verfahren nach Anspruch 6,
**dadurch gekennzeichnet, dass**
unterschiedliche Kompressionsgrade definiert werden, um die Verlaufsmuster von den ersten Signalen zu komprimieren, die gleichzeitig jeweils an einen der zu prüfenden Schaltkreise geschickt werden.

8. Verfahren nach einem der Ansprüche 1 bis 7,
**dadurch gekennzeichnet, dass**
das elektronische Bauteil in Abhängigkeit von einem Grad der Kompression eingestuft wird, die durchgeführt wird, um die Dauer des Verlaufsmusters des ersten Signals zu komprimieren.

9. Verfahren nach einem der Ansprüche 1 bis 8,
**dadurch gekennzeichnet, dass**
an einen Schaltkreis nach einem Bauteil oder ein nachfolgendes Bauteil ein erstes Signal geschickt wird, das als Verlaufsmuster das komprimierte Verlaufsmuster aufweist, das für einen voher geprüften Schaltkreis oder ein vorher geprüftes Bauteil definiert wurde.

10. Verfahren nach einem der Ansprüche 1 bis 9,
**dadurch gekennzeichnet, dass**
das Bauteil gealtert wird, indem es wiederholten Änderungen der Temperatur unterworfen wird und dann
ein erstes Signal mit einer ersten Dauer mit einem ersten, nicht monotonen Verlaufsmuster an eine erste Zelle des Bauteils geschickt wird,
ein Ergebnis gemessen wird, das durch ein erstes Muster von elektrischen Zuständen der ersten Zelle dargestellt wird.

11. Verfahren nach einem der Ansprüche 1 bis 10,
**dadurch gekennzeichnet, dass**
als erstes Signal ein Programmierungssignal an eine Speicherzelle eines integrierten Speicherschaltkreises des elektronischen Bauteils, insbesondere ein flash- EPROM-Speicher, geschickt wird,
die Speicherzelle am Ende des Prüfvorgangs gelöscht wird.

## Claims

1. A method for the testing of an electronic component wherein:
- a first signal is sent, with first duration, with a first non-monotonic historical pattern to a first cell of the component,
- a measurement is made of a result represented by a first pattern of electric states of the first cell,
- the component is accepted if the first pattern of states conforms to an expected pattern,
wherein
- the duration of the historical pattern of the first signal is compressed,
- a compressed pattern of corresponding states is measured, and
- the component is accepted if the compressed pattern of states conforms to an expected compressed pattern.

2. A method according to claim 1 wherein:
- a clock is used to determine a step of sequencing of elements of the first historical pattern, such that the step of this clock can be diminished.

3. A method according to one of the claims 1 to 2 wherein:
- a table is constituted from a sampling of the first historical pattern,
- a duration of sending of a signal whose historical pattern is a sequence of samples of this table corresponds to a compressed duration of the historical pattern.

4. A method according to one of the claims 1 to 3 wherein:
- a group of tables is constituted from samplings of the first historical pattern,
- this group of tables representing possible historical patterns to obtain compressed historical patterns with different compression rates.

5. A method according to one of the claims 1 to 4 wherein:
- a test comprises several historical patterns to be tested on the cell of the component,
- respective durations of different historical patterns of first signals are compressed differently.

6. A method according to one of the claims 1 to 5 wherein:
- several circuits of one and the same electronic component are tested simultaneously.

7. A method according to claim wherein:
- different compression rates are defined to compress historical patterns of first signals, each sent simultaneously to one of the circuits to be tested.

8. A method according to one of the claims 1 to 7 wherein:
- the electronic component is qualified as a function of the compression rate implemented to compress the duration of the historical pattern of the first signal.

9. A method according to one of the claims 1 to 8 wherein:
- a first signal is sent to a following circuit of a component or to a following component, this first signal having a historical pattern that is the compressed historical pattern defined for a circuit or a component previously tested.

10. A method according to one of the claims 1 to 9 wherein:
- the component is aged by making it undergo repeated temperature variations, then
- a first signal with a first duration, with a first non-monotonic historical pattern, is sent to a first cell of the component, and
- a result represented by a first pattern of electrical states of the first cell is measured.

11. A method according to one of the claims 1 to 10 wherein:
- as a first signal, a programming signal is sent to a memory cell of an integrated circuit memory of the electronic component, in particular, a Flash-EPROM type memory,
- the memory cell is erased at the end of the test.
